# EUROPÄISCHE PATENTSCHRIFT

(11) **EP 1 796 175 B1**
(45) Veröffentlichungstag und Bekanntmachung des Hinweises auf die Patenterteilung: **05.11.2008**
(21) Anmeldenummer: 06024764.0
(22) Anmeldetag: 30.11.2006
(51) Int. Cl.: H01L 29/78, H01L 29/06, H01L 29/08, H01L 29/423

(54) **DMOS-Transistor mit optimierter Randstruktur**
DMOS Transistor with optimised peripheral structure
Transistor DMOS avec structure périphérique optimisée

(30) Priorität: 09.12.2005 DE 102005060521
(43) Veröffentlichungstag der Anmeldung: 13.06.2007
(73) Patentinhaber: ATMEL Germany GmbH, 74072 Heilbronn (DE)
(72) Erfinder: Dietz, Franz, 74257 Untereisesheim (DE); Graf, Michael, 71397 Leutenbach (DE); Schwantes, Stefan, 74080 Heilbronn (DE)
(74) Vertreter: Müller, Wolf-Christian

(56) Entgegenhaltungen:
- EP-A2- 1 286 399
- US-A1- 2005 145 930
- US-B1- 6 441 432
- SUNKAVALLI R ET AL: "HIGH TEMPERATURE PERFORMANCE OF DIELECTRICALLY ISOLATED LDMOSFET : CHARACTERIZATION, SIMULATION AND ANALYSIS" PROCEEDINGS OF THE INTERNATIONAL SYMPOSIUM ON POWER SEMICONDUCTOR DEVICES (ISPSD), Bd. SYMP. 6, 31. Mai 1994 (1994-05-31), Seiten 359-364, XP000505838

## Beschreibung

Die Erfindung betrifft einen lateralen DMOS-Transistor gemäß dem Oberbegriff des Anspruchs 1. Ein solcher DMOS-Transistor ist aus der EP 1 286 399 A2 bekannt.

Unter einem DMOS-Transistor wird ein Feldeffekttransistor mit einem Source-Bereich, einem Kanalbereich und einem Drain-Bereich verstanden, bei dem der Drain-Bereich durch eine Driftregion von dem Kanalbereich getrennt ist. Während die Leitfähigkeit des Kanalbereichs durch eine Gate-Spannung gesteuert wird, mit der ein Auftreten und eine Stärke einer Inversion der Konzentrationen positiver oder negativer Ladungsträger unterhalb des Gates gesteuert wird, ist die Ladungsträgerkonzentration in der Driftregion im Wesentlichen konstant, so dass sich dort näherungsweise eine Ohm'sche Leitfähigkeit ergibt. Der im Betrieb des Transistors über der Driftregion auftretende Spannungsabfall reduziert den über dem Kanal auftretenden Anteil der Drain-Source-Spannung, was zu einer erhöhten Durchbruchspannung des Transistors führt.

Bei einem lateralen DMOS-Transistor ist der Stromfluss und der Kanalbereich im Wesentlichen parallel zur Oberfläche des Wafers ausgerichtet, während er in einem vertikalen DMOS-Transistor im Wesentlichen in Richtung einer Normalen zur Waferoberfläche ausgerichtet ist. Der laterale DMOS-Transistor kann daher von einer Seite kontaktiert werden, während der vertikale DMOS-Transistor von zwei Seiten des Wafers angeschlossen werden muss.

DMOS-Transistoren werden häufig als Treibertransistoren zur Ansteuerung von induktiven Lasten, insbesondere im Automobilbereich, eingesetzt und sollen eine möglichst hohe Durchbruchspannung bei gleichzeitig minimalem Flächenbedarf aufweisen. Um Kanten und Ecken zu vermeiden, an denen aufgrund der elektrischen Spitzenwirkung lokal unerwünscht hohe Feldstärken entstehen könnten, ist es per se bekannt, DMOS-Transistoren mit den oben angegebenen Merkmalen und damit mit einer Stadionstruktur herzustellen. Bei der herkömmlichen Stadionstruktur ist ein Abstand zwischen der ersten dielektrischen Struktur, die im Allgemeinen als Feldgebiet bezeichnet wird, und der Grenzlinie längs der geraden Abschnitte genauso groß wie längs der gekrümmten Abschnitte.

Die Veröffentlichung "High Temperature Performance of Dielectrically Isolated LDMOSFET: Characterization, Simulation and Analysis", Proceedings of the International Symposium on Power Semiconductor Devices (ISPSD), Bd. SYMP.6, 31. Mai 1994, Seiten 359-364, XP000505838 zeigt einen lateralen DMOSFET mit einer solchen Stadionstruktur und beschäftigt sich mit seinem Temperaturverhalten. In den gekrümmten Bereichen der Stadionstruktur ergibt sich die Länge einer Driftregion als konstanter Wert einer Differenz von zwei Radien konzentrischer Halbkreise.

Die EP 1 286 399 A1 zeigt ebenfalls einen lateralen DMOS-Transistor mit einer Stadionstruktur. Dort ist ein erster Bereich (p-type Well) von einem zweiten Bereich (n-type Well) umgeben. In den zweiten Bereich ist ein Feldoxid eingebettet, das ebenfalls die Stadionstruktur mit geraden Bereichen und gekrümmten Bereichen aufweist. Der Abstand des inneren Rands dieses Feldoxides zur Grenze zwischen dem ersten Bereich und dem zweiten Bereich ist in den gekrümmten und geraden Bereichen gleich. Der Abstand des äußeren Rands des Feldoxides zur Grenze zwischen dem ersten Bereich und dem zweiten Bereich ist in den gekrümmten Bereichen größer als in den geraden Bereichen.

Eine laterale DMOS-Stadionstruktur mit konstanter Länge einer Driftregion ist darüber hinaus auch aus der US 6 441 432 B1 bekannt.

Obwohl sich mit den Stadionstrukturen bereits hohe Durchbruchspannungen bei geringer Baugröße realisieren lassen, besteht nach wie vor ein Bedarf nach weiterer Optimierung des Verhältnisses aus Durchbruchspannung und Baugröße, um die Fläche der DMOS-Transistoren weiter zu verringern und die Herstellungskosten zu senken.

In einem alternativen Ansatz wurde eine lithografische Strukturierung der Driftregion in den gekrümmten Randbereichen mit dem Ziel verwendet, dort die Dotierung zu verringern. Es hat sich jedoch bei Bauelementesimulationen und elektrischen Messungen gezeigt, dass die Durchbruchspannung der Driftregion bei einer bestimmten Dotierung optimal ist und sowohl für größere als auch für kleinere Dotierungen abnimmt. Dies liegt an dem sogenannten RESURF (Reduced Surface Field) Effekt, der wesentlich zur hohen Durchbruchspannung des Bauelements beiträgt. Dieser Effekt kann sowohl für zu kleine als auch für zu große Dotierungen der Driftregion nicht optimal genutzt werden.

Vor diesem Hintergrund besteht die Aufgabe der Erfindung in der Angabe einer DMOS-Transistorstruktur mit verbessertem Verhältnis zwischen Durchbruchspannung und Baugröße.

Diese Aufgabe wird bei einem DMOS-Transistor der eingangs genannten Art durch die Merkmale des Anspruchs 1 gelöst.

Es hat sich gezeigt, dass bei der neuen Struktur unter vergleichbaren Bedingungen geringere Feldstärken auftreten als bei der bekannten Stadionstruktur. Da bei der bekannten Stadionstruktur die dort höheren Feldstärken die Durchbruchspannung stärker begrenzt haben, weist die neue Struktur eine höhere Durchbruchspannung bei gleicher Baugröße oder eine geringere Baugröße bei gleicher Durchbruchspannung auf. So hat sich beispielsweise bei einer Verringerung des Abstands von einem Ausgangswert von 0,9 *µm* auf 0,6 *µm* eine Erhöhung der Durchbruchspannung von ca. 65 V auf ca. 83 V und bei einer weiteren Verringerung auf 0,3 *µm* eine Erhöhung auf ca. 88 Vergeben .

Dabei ist bevorzugt, dass sich der Abstand stetig verändert. Durch dieses Merkmal werden kontraproduktive Ecken oder Kanten vermieden, an denen bekanntlich überhöhte Feldstärken auftreten (Spitzenwirkung).

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: eine Draufsicht auf einen Teil eines lateralen DMOS-Transistors;
- Fig. 2: einen ersten Schnitt durch den DMOS-Transistor aus der Fig. 1; und
- Fig. 3: einen zweiten Schnitt durch den DMOS-Transistor aus der Fig. 1.

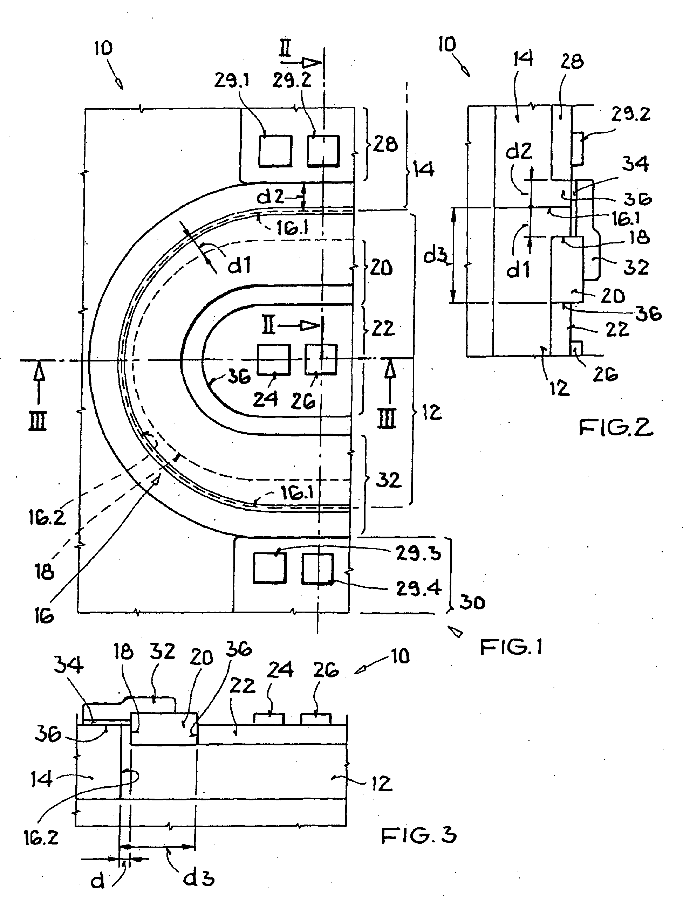

Im Einzelnen zeigt die Fig. 1 eine linke Hälfte eines lateralen DMOS-Transistors 10, der gerade und gekrümmte Bereiche aufweist, die zusammen eine Form ergeben, die an die Form eines Stadions oder einer Laufbahn eines Stadions erinnern. Ein erster Bereich 12 aus Halbleitermaterial eines ersten Leitfähigkeitstyps bildet einen inneren Bereich, der seitlich von einem zweiten, äußeren Bereich 14 aus Halbleitermaterial eines zweiten Leitfähigkeitstyps umgeben ist. Dies wird auch durch die Figuren 2 und 3 verdeutlicht. In der Darstellung der Fig. 1 bis 3 besitzt das Halbleitermaterial des ersten Leitfähigkeitstyps eine p-Leitfähigkeit und das Halbleitermaterial des zweiten Leitfähigkeitstyps besitzt eine n-Leitfähigkeit. Eine in der Fig. 1 gestrichelt dargestellte Grenzlinie 16 markiert die Grenze zwischen dem ersten Bereich 12 und dem zweiten Bereich 14. Dabei weist die Grenzlinie 16 gerade Abschnitte 16.1 und gekrümmte Abschnitte 16.2 auf.

Eine weitere gestrichelte Linie markiert eine äußere Grenze 18 einer ersten dielektrischen Struktur 20, die in den ersten, inneren Bereich 12 eingebettet ist. Die erste dielektrische Struktur 20, die auch als Feldgebiet oder Isolationsgebiet bezeichnet wird, kann zum Beispiel als shallow trench isolation (STI) realisiert sein. Ein erster Abstand d1 zwischen der dielektrischen Struktur 20 und der Grenzlinie 16 ist längs der geraden Abschnitte 16.1 größer als längs des gekrümmten Abschnitts 16.2. Die erste dielektrische Struktur umgibt einen Teilbereich 22 des ersten Bereichs 12, der stärker dotiert ist als der übrige erste Bereich 12. Dieser Teilbereich 22 dient im Betrieb des Transistors 10 als Drain-Bereich und besitzt hochleitfähige Anschlusskontakte 24, 26, die zum Beispiel aus Metall oder Polysilizium bestehen können.

Längs der geraden Abschnitte 16.1 erstrecken sich streifenförmige Gebiete 28, 30 des ersten Leitfähigkeitstyps in einem zweiten Abstand d2 zur Grenzlinie 16. Die streifenförmigen Gebiete 28, 30 sind bevorzugt stärker dotiert als der erste Bereich und der zweite Bereich und dienen im Betrieb des Transistors 10 als Source-Bereiche. Sie weisen daher ebenfalls hochleitfähige Anschlusskontakte 29.1, 29.2, 29.3, 29.4 auf.

Auf der ersten dielektrischen Struktur liegt eine Schicht 32 aus hochleitfähigem Material, die sich bis zu den streifenförmigen Source-Bereichen 28, 30 erstreckt. Sie bedeckt damit auch eine zwischen der ersten dielektrischen Struktur 20 und den streifenförmigen Bereichen 28, 30 liegende dünne zweite dielektrische schichtförmige Struktur, die als Gate-Dielektrikum dient.

Die als Gateschicht, Gateoxid oder Gatedielektrikum dienende zweite dielektrische Struktur ist in den Querschnitten der Figuren 2 und 3 mit der Ziffer 34 bezeichnet. Im Übrigen bezeichnen gleiche Ziffern in den Figuren 1 bis 3 jeweils gleiche Elemente.

Zwischen den streifenförmigen Gebieten 28, 30 und der Grenzlinie 16 erstreckt sich ein Kanalbereich 36, der durch die zweite dielektrische Struktur 34 bedeckt ist. Die als Gateoxid dienende zweite dielektrische Struktur 34 ist dünner als die das Feldgebiet bildende erste dielektrische Struktur 20 und geht in die erste dielektrische Struktur 20 über. Dabei umgibt die zweite dielektrische Struktur 34 die erste dielektrische Struktur 20 vollständig und reicht überall über die Grenzlinie 16 hinaus. Bei entsprechendem Potenzial der Gate-Elektrode 32, die auf der als Gateoxid dienenden zweiten dielektrischen Schicht 34 liegt, kommt es zur Inversion der Ladungsträgerkonzentrationen im Kanalbereich, wodurch ein durchgängiger Pfad vom ersten Leitfähigkeitstyp zwischen Source-Bereich 28 und Drain-Bereich 22 entsteht. Der im Pfad zwischen dem Drain-Bereich 22 und dem Kanalbereich liegende Teil des ersten Bereichs 12 bildet die Driftregion.

Wie aus sämtlichen Figuren 1, 2 und 3 hervorgeht, ist der erste Abstand d1 zwischen der ersten dielektrischen Struktur 20 und der Grenzlinie 16 längs der geraden Abschnitte 16.1 größer als längs der gekrümmten Abschnitte 16.2. Diese Verhältnisse können zum Beispiel dadurch erzeugt werden, dass eine Breite der ersten dielektrischen Struktur 20 längs der geraden Abschnitte 16.1 kleiner oder gleich ihrer Breite längs der gekrümmten Abschnitte 16.2 ist und ein dritter Abstand d3 zwischen der Grenzlinie 16 und einer inneren Kante 36 der ersten dielektrischen Struktur 20 längs der gekrümmten Abschnitte 16.2 kleiner ist als längs der geraden Abschnitte 16.1. Bei gleicher Breite rückt daher die Grenzlinie im gekrümmten Beeich näher an die innere Kante 36 heran als längs der geraden Abschnitte 16.1. Alternativ kann der dritte Abstand d3 zwischen der inneren Kante 36 und der Grenzlinie 16 aber auch konstant sein, wenn die erste dielektrische Struktur 20 in den gekrümmten Bereichen verbreitert wird.

Mit Blick auf die Figuren 1 bis 3 wurde die Erfindung am Beispiel eines p-Kanal-DMOS-Transistors erläutert. Es versteht sich aber, dass die Erfindung auch mit einem n-Kanal-DMOS realisiert werden kann. In diesem Fall, das Realisierung eines n-Kanal-DMOS ist als Halbleitermaterial des ersten Leitfähigkeitstyps ein n-leitendes Halbleitermaterial und als Halbleitermaterial des zweiten Leitfähigkeitstyps ein p-leitendes Halbleitermaterial zu verwenden. Im Betrieb des n-Kanal-DMOS ist an die Gateelektrode ein positives Potenzial anzulegen, um zwischen der Drainelektrode und der Sourceelektrode im Wege der Inversionsschichtbildung ein n-Kanal-Gebiet unter dem Gateoxid zu bilden.

## Patentansprüche

1. Lateraler DMOS-Transistor (10) mit einem ersten Bereich (12) eines ersten Leitfähigkeitstyps, der seitlich von einem zweiten Bereich (14) eines zweiten Leitfähigkeitstyps umgeben ist, wobei eine Grenzlinie (16) zwischen beiden Bereichen (12, 14) einander gegenüberliegende gerade Abschnitte (16.1) sowie die geraden Abschnitte (16.1) verbindende wenigstens teilweise gekrümmte Abschnitte (16.2) aufweist, und mit einer als Feldgebiet dienenden ersten dielektrischen Struktur (20), die einen Teilbereich (22) des ersten Bereichs (114) umgibt, **dadurch gekennzeichnet, dass** die erste dielektrische Struktur (20) in den ersten Bereich (12) eingebettet ist und ein erster Abstand (d1) zwischen der ersten dielektrischen Struktur (20) und der Grenzlinie (16) längs der geraden Abschnitte (16.1) größer ist als längs der gekrümmten Abschnitte (16.2).

2. DMOS-Transistor (10) nach Anspruch 1, **dadurch gekennzeichnet, dass** Änderungen des ersten Abstands (d1) stetig erfolgen.

3. DMOS-Transistor (10) nach Anspruch 1 oder 2, **dadurch gekennzeichnet, dass** eine Breite der ersten dielektrischen Struktur (20) längs der geraden Abschnitte (16.1) kleiner oder gleich ihrer Breite längs der gekrümmten Abschnitte (16.2) ist und ein dritter Abstand (d3) zwischen der Grenzlinie (16) und einer inneren Kante (38) der ersten dielektrischen Struktur (20) längs der gekrümmten Abschnitte (16.2) kleiner ist als längs der geraden Abschnitte (16.1).

4. DMOS-Transistor (10) nach wenigstens einem der Ansprüche 1 bis 3, **gekennzeichnet durch** streifenförmige Gebiete (28, 30) des ersten Leitfähigkeitstyps, die sich längs der geraden Abschnitte (16.1) in einem zweiten Abstand (d2) zur Grenzlinie erstrecken und einen Kanalbereich begrenzen.

5. DMOS-Transistor (10) nach Anspruch 4, **dadurch gekennzeichnet, dass** die streifenförmigen Gebiete(28, 30) stärker dotiert sind als der erste Bereich (12) und der zweite Bereich (14).

6. DMOS-Transistor (10) nach Anspruch 4, **dadurch gekennzeichnet, dass** der Kanalbereich durch eine als Gatedielektrikum dienende zweite dielektrische Struktur (34) bedeckt ist, die dünner als die als Feldgebiet dienende erste dielektrische Struktur (20) ist und die in die erste dielektrische Struktur (20) übergeht.

7. DMOS-Transistor (10) nach Anspruch 4, **dadurch gekennzeichnet, dass** die zweite dielektrische Struktur (34) die erste dielektrische Struktur (20) vollständig umgibt und überall über die Grenzlinie (16) hinaus reicht.

8. DMOS-Transistor (10) nach wenigstens einem der vorhergehenden Ansprüche, **dadurch gekennzeichnet, dass** ein von der ersten dielektrischen Struktur (20) umgebener Teilbereich (22) des ersten Bereichs (12) stärker dotiert ist als der übrige erste Bereich (12).

9. DMOS-Transistor (10) nach wenigstens einem der vorhergehenden Ansprüche, **dadurch gekennzeichnet, dass** der erste Leitfähigkeitstyp einer p-Leitfähigkeit und der zweite Leitfähigkeitstyp einer n-Leitfähigkeit entspricht.

10. DMOS-Transistor (10) nach wenigstens einem der Ansprüche 1 bis 8, **dadurch gekennzeichnet, dass** der erste Leitfähigkeitstyp einer n-Leitfähigkeit und der zweite Leitfähigkeitstyp einer p-Leitfähigkeit entspricht.

## Claims

1. Lateral DMOS transistor (10) with a first region (12) of a first conductivity type, which is laterally surrounded by a second region (14) of a second conductivity type, wherein a boundary line (16) between the two regions (12, 14) has mutually opposite straight sections (16.1) as well as sections (16.2), which are curved at least in part, connecting the straight sections (16.1), and with a first dielectric structure (20), which serves as field zone (20) and which surrounds a sub-region (22) of the first region (114), **characterised in that** the first dielectric structure (20) is embedded in the first region (12) and a first spacing (d1) between the first dielectric structure (20) and the boundary line (16) along the straight sections (16.1) is greater than along the curved sections (16.2).

2. DMOS transistor (10) according to claim 1, **characterised in that** changes in the first spacing (d1) take place progressively.

3. DMOS transistor (10) according to claim 1 or 2, **characterised in that** a width of the first dielectric structure (20) along the straight sections (16.1) is smaller than or equal to the width thereof along the curved sections (16.2) and a third spacing (d3) between the boundary line (16) and an inner edge (38) of the first dielectric structure (20) along the curved sections (16.2) is smaller than along the straight sections (16.1).

4. DMOS transistor (10) according to at least one of claims 1 to 3, **characterised by** strip-shaped zones (28, 30) of the first conductivity type, which extend along the straight sections (16.1) at a second spacing (d2) from the boundary line and delimit a channel region.

5. DMOS transistor (10) according to claim 4, **characterised in that** the strip-shaped zones (28, 30) are more strongly doped than the first region (12) and the second region (14).

6. DMOS transistor (10) according to claim 4, **characterised in that** the channel region is covered by a second dielectric structure (34), which serves as gate dielectric and which is thinner than the first dielectric structure (20), which serves as field zone, and goes over into the first dielectric structure (20).

7. DMOS transistor (10) according to claim 4, **characterised in that** the second dielectric structure (34) completely surrounds the first dielectric structure (20) and extends everywhere beyond the boundary line (16).

8. DMOS transistor (10) according to at least one of the preceding claims, **characterised in that** a sub-region (22), which is surrounded by the first dielectric structure (20), of the first region (12) is more strongly doped than the rest of the first region (12).

9. DMOS transistor (10) according to at least one of the preceding claims, **characterised in that** the first conductivity type corresponds with a p conductivity and the second conductivity type corresponds with an n conductivity.

10. DMOS transistor (10) according to at least of claims 1 to 8, **characterised in that** the first conductivity type corresponds with an n conductivity and the second conductivity type corresponds with a p conductivity.

## Revendications

1. Transistor DMOS latéral (10) comprenant une première zone (12) d'un premier type de conductivité, entourée latéralement par une deuxième zone (14) d'un deuxième type de conductivité, dans lequel une ligne de délimitation (16) entre les deux zones (12, 14) présente des portions droites (16.1) se faisant face ainsi que des portions au moins partiellement courbes (16.2) reliant les portions droites (16.1), transistor comprenant également une première structure diélectrique (20) servant de zone de champ, qui entoure une zone partielle (22) de la première zone (12), **caractérisé en ce que** la première structure diélectrique (20) est enterrée dans la première zone (12) et **en ce qu'**un premier intervalle (d1) entre la première structure diélectrique (20) et la ligne de délimitation (16) le long des portions droites (16.1) est plus grand que celui le long des portions courbes (16.2).

2. Transistor DMOS (10) selon la revendication 1, **caractérisé en ce que** le premier intervalle (1) se modifie constamment.

3. Transistor DMOS (10) selon la revendication 1 ou 2, **caractérisé en ce qu'**une largeur de la première structure diélectrique (20) le long des portions droites (16.1) est inférieure ou égale à sa largeur le long des portions courbes (16.2), et **en ce qu'**un troisième intervalle (d3) entre la ligne de délimitation (16) et une bordure intérieure (36) de la première structure diélectrique (20) le long des portions courbes (16.2) est plus petit que celui le long des portions droites (16.1).

4. Transistor DMOS (10) selon l'une au moins des revendications 1 à 3, **caractérisé par** des zones en bandes (28, 30) du premier type de conductivité, qui s'étendent le long des portions droites (16.1) à un deuxième intervalle (d2) de la ligne de délimitation et délimitent une zone de canal.

5. Transistor DMOS (10) selon la revendication 4, **caractérisé en ce que** les zones en bandes (28, 30) sont plus fortement dopées que la première zone (12) et la deuxième zone (14).

6. Transistor DMOS (10) selon la revendication 4, **caractérisé en ce que** la zone de canal est recouverte par une deuxième structure diélectrique (34) servant de diélectrique de grille, plus mince que la première structure diélectrique (20) servant de zone de champ et qui se fond dans la première structure diélectrique (20).

7. Transistor DMOS (10) selon la revendication 4, **caractérisé en ce que** la deuxième structure diélectrique (34) entoure complètement la première structure diélectrique (20) et s'étend partout au-delà de la ligne de délimitation (16).

8. Transistor DMOS (10) selon l'une au moins des revendications précédentes, **caractérisé en ce qu'**une zone partielle (22) de la première zone (12) entourée par la première structure diélectrique (20) est plus fortement dopée que le reste de la première zone (12).

9. Transistor DMOS (10) selon l'une au moins des revendications précédentes, **caractérisé en ce que** le premier type de conductivité correspond à une conductivité de type P et le deuxième type de conductivité à une conductivité de type N.

10. Transistor DMOS (10) selon l'une au moins des revendications 1 à 8, **caractérisé en ce que** le premier type de conductivité correspond à une conductivité de type N et le deuxième type de conductivité à une conductivité de type P.
